# EUROPEAN PATENT SPECIFICATION

(11) **EP 4 422 367 B1**
(45) Date of publication and mention of the grant of the patent: **05.08.2026**
(21) Application number: 23158424.4
(22) Date of filing: 24.02.2023
(51) Int. Cl.: H05K 7/20

(54) **A SYSTEM, METHOD AND USE FOR PROVIDING THERMAL CAPACITY, GENERATED AS WASTE HEAT BY SOLID STATE TECHNOLOGY, TO CUSTOMERS**
SYSTEM, VERFAHREN UND VERWENDUNG ZUR BEREITSTELLUNG VON ALS ABWÄRME DURCH FESTKÖRPERTECHNOLOGIE ERZEUGTER THERMISCHER KAPAZITÄT FÜR KUNDEN
SYSTÈME, PROCÉDÉ ET UTILISATION POUR FOURNIR À DES CLIENTS UNE CAPACITÉ THERMIQUE, GÉNÉRÉE EN TANT QUE CHALEUR PERDUE PAR UNE TECHNOLOGIE À SEMI-CONDUCTEURS

(43) Date of publication of application: 28.08.2024
(73) Proprietor: BonCalor AB, 852 71 Sundsvall (SE)
(72) Inventor: WALLIN, Lars, SE-857 32 SUNDSVALL (SE); MELIN, Tomas, SE-163 47 SPÅNGA (SE)
(74) Representative: Bjerkén Hynell KB

(56) References cited:
- EP-B1- 2 555 604
- EP-B1- 3 146 161
- WO-A1-2022/184923
- US-A1- 2005 207 116
- US-A1- 2009 198 388

## Description

### TECHNICAL FIELD

The invention relates to a system for providing heat capacity to customers from solid state technology, wherein heat capacity is generated by at least one solid state thermal generator, situated at an optimal distance to the customers. The system provides compute capacity by the solid state thermal generator while heat capacity is generated, as defined by appended claim 1.

The invention also relates to a method for providing heat capacity to customers in the system, as defined by appended claim 9.

### BACKGROUND

The invention is advantageously used for providing heat capacity from a solid state thermal generator to customers at an optimal distance to the solid state thermal generator while the solid state thermal generator provides compute capacity at the same time.

Traditional industries and other commercial activities that require a high heat capacity in their processes are often dependent on specific logistical solutions for energy transportation. Fossil fuel and bio fuel require transportation and storage of the fuel. Hence, these logistical solutions result in that capital in fuel storage and infrastructure is locked up as well as business risks due to environmental permits.

Electrical energy is much easier to transport but suffers from high exergy loss when used for heating. Further, customers in traditional industries and other commercial activities need primarily that a total requirement of heat capacity can be provided, that a sufficient temperature of the heat capacity can be delivered and that the requirement for heat capacity provided can be scheduled during the year.

Consequently, there may be a lot of different criteria that need to be considered when providing heat capacity generated from electricity.

The following definitions are used in the description and the appended claims:
- Compute Capacity is the digital processing capacity that can be delivered globally
- Heat Capacity is the heat generated by the Solid State Thermal Generator (SSTG)
- Electrical Energy Supply is the green source or zero carbon footprint
- Circular Components are systems that can connect to Heat Capacity and reuse the energy
- Heat Capacity Management Systems means the control system that regulates the provision of Heat Capacity
- A solid state thermal generator (SSTG) is capable of transferring electrical energy into thermal energy for heating or cooling

A desire is to provide heat capacity from solid state technology, such as a solid state thermal generator, to customers close to the solid state thermal generator providing heat capacity as well as it produces compute capacity.

Further, it is a desire to provide a system that is cost efficient and able to reach large cost savings in the use of electric energy for heating buildings, industries and other facilities in commercial activities.

Yet a further desire is that the compute work provided in the solid state thermal generator can be sold, leased, rent, or put on the market in other ways, alternatively be dumped.

A further desire is that the compute capacity can be conveyed via internet or other transportation protocols.

There is also a desire to eliminate the use of the logistic solutions for energy transportation and chemical fuels in traditional industries and other commercial activities.

US9554491 B1 discloses a data center cooling system includes a cooling liquid supply conduit fluidly coupled between a cooling plant and an air-to-liquid heat exchanger positioned to receive a heated airflow from one or more racks. At least one rack supports a plurality of heat-generating electronic devices. The system further includes a cooling liquid return conduit fluidly coupled between the cooling plant and the air-to-liquid heat exchanger; and a heat transfer module thermally coupled to the cooling liquid supply and return conduits between the cooling plant and the air-to-liquid heat exchanger. The heat transfer module includes a cold side and a warm side, with the cold side thermally coupled to the cooling liquid supply conduit to transfer heat from a flow of a cooling liquid in the cooling liquid supply conduit to the warm side of the heat transfer module, and the warm side including a heat sink.

However, US9554491 B1 describes mainly a cooling system for a data center and does not disclose the means for providing heat capacity from solid state technology, such as a solid state thermal generator, to customers in the vicinity to the solid state thermal generator while the solid state thermal generator provides compute capacity at the same time.

EP2555604B1 discloses a data center with air cooling, where the waste heat is recovered and used for heating other buildings or sanitary water.

EP2146161 B1 discloses a data center with air cooling, where the waste heat is recovered and used either for heating purposes or to generate power.

WO2022/184923A1 discloses a liquid cooled data center, specifically meant to generate heat for customers, wherein the calculating power is varied to match the demand in heating.

US2009/198388A1 and US2005/207116A1 disclose air cooled data centers, wherein air is passing through a sandwich structure of a rack with heat generating computing nodes, a fan wall and a heat exchanger, before entering a next such sandwich structure.

### SUMMARY

An object of the invention is to improve the use of heat capacity provided by solid state technology when providing compute capacity.

Another object of the invention is to provide heat capacity from solid state technology, such as a solid state thermal generator, to customers in the vicinity to a solid state thermal generator wherein the solid state thermal generator also produces compute capacity to customers.

A further object is to be able to provide a system that is cost efficient and able to reach large cost savings in the use of electric energy for heating buildings, industries, residential buildings and other facilities.

Yet a further object is that the compute capacity provided in the solid state thermal generator can be sold, leased, rented, or put on the market in other ways, alternatively be dumped to the environment.

Further, it is a desire to provide a compute capacity that can be delivered globally via internet or other transportation protocols.

The objects are achieved by a system according to claim 1.

As a result, an improved use of heat capacity provided by a solid state thermal generator when providing compute capacity can be provided. Thanks to the fact that the heat capacity from the solid state thermal generator is provided to customers, in the same time as the solid state thermal generator produces compute capacity to customers, an energy efficient system and a cost saving improvement for providing heat capacity to customers is created. The use of electric energy for heating buildings, industries and other facilities in commercial activities is improved.

According to an aspect of the invention, the cooling agent is a refrigerant comprising air, an inert gas, a gas mixture, or a fluid medium.

According to a further aspect of the invention, the fluid medium can be either gas or liquid phase.

According to yet a further aspect of the invention the heat capacity from the solid state thermal generator is provided to customers in the vicinity to the solid state thermal generator. Thanks to the fact that the heat capacity from solid state thermal generators is provided to customers in the vicinity to the solid state thermal generator, in the same time as the solid state thermal generator produces compute capacity to customers, an energy efficient system and a cost saving improvement for providing heat capacity to customers is created.

According to another aspect of the invention the customers facilities such as buildings, industries and other facilities for commercial activities are preferably at a typical district heating distance from the solid state thermal generator or less.

According to yet another aspect of the invention, wherein the compute unit may include a least a few, but preferably a plurality of processors. Preferably, the system comprises processor clusters in the range of about 3 kW up to 30 kW. This results in a system that is cost efficient and can be adapted for any customer, large or small.

According to a further aspect of the invention, wherein the amount of heat power generated, that is the computational core of computers/processors in the compute units, is controlled by altering the computational load on the core. Hence it is possible to provide a system that is cost efficient and able to reach large cost savings in the use of electric energy for heating buildings, industries, residential buildings and other facilities.

According to yet a further aspect of the invention, wherein the system has a heat pumping and storage system to store heat capacity during low demand periods and deliver heat capacity during peak demand. Thus, the system for providing heat capacity can be very cost efficient.

According to another aspect of the invention, wherein the system, as a by-product, delivers computational power for scientific, industrial, commercial or private purposes which can be consumed locally or delivered through the internet. Thus, the compute capacity provided in the solid state thermal generator can be sold, leased, rented, or put on the market in other ways.

According to yet another aspect of the invention, wherein the computational power is sold on the market using a computer controlled brokering system. Hence, the system can be cost efficient.

Further, the objects are also achieved by a method, according to the invention, for providing heat capacity to customers in the system.

The objects are also achieved by a use of the system, according to the invention, for providing heat capacity from a solid state thermal generator to customers in the vicinity of the solid state thermal generator, while providing compute capacity.

Further advantages and advantageous features of the invention are disclosed in the following description and in the dependent claims.

### BRIEF DESCRIPTION OF THE DRAWINGS

Below, embodiments of the invention will be described with reference to the drawings, in which:
- fig. 1 shows a module comprising a compute unit, a fan unit and a heat exchanger unit according to an embodiment of the invention,
- fig. 2 shows a solid state thermal generator having several modules as shown in fig. 1, and
- fig. 3 shows a wiring diagram for a system providing heat capacity from a solid state thermal generator with three modules as shown in figs 1 and 2, according to an embodiment of the invention.

### DETAILED DESCRIPTION OF EMBODIMENTS OF THE INVENTION

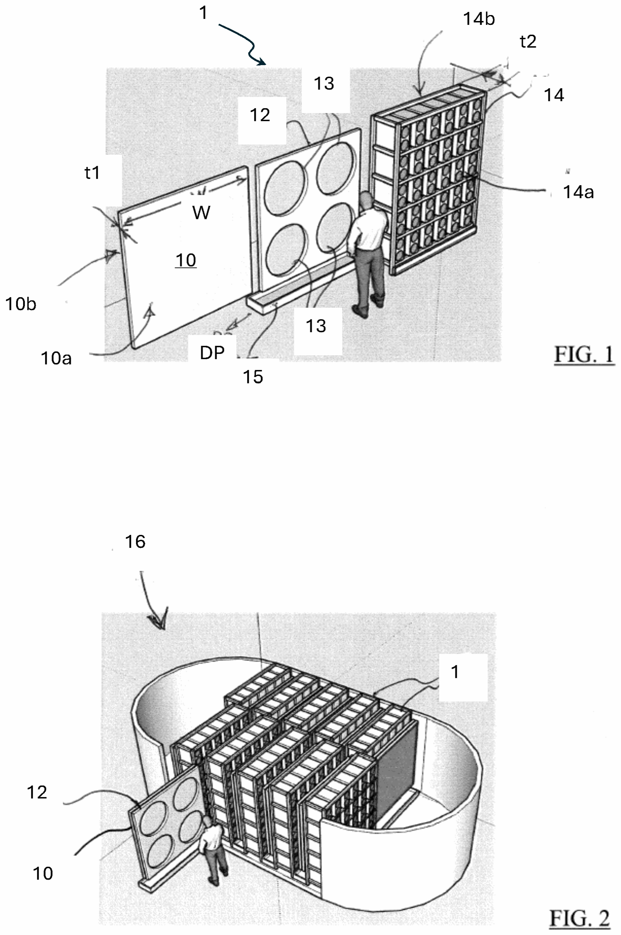

Fig. 1 shows a module 1 suitable for a solid state thermal generator (SSTG) according to an embodiment of the invention. The module comprising a compute unit 10, a fan unit 12 and a heat exchanger unit 14 according to an embodiment of the invention. The compute unit 10 is schematically shown as a first quadratic element with a large, widely-spread front side surface 10a and an opposite corresponding back side surface 10b. The thickness t1 of the first quadratic element may be relatively thin.

The compute unit 10 may include a least a few, but preferably a plurality of calculating processors, such as a central processing unit (CPU), microprocessors or a graphics processing unit (GPU) etc. Basically, according to the present invention, any processors can be used for generating heat capacity or providing compute capacity. However, it is preferred to use processor clusters in the range of about 1 kW up to installed electrical power, suitably processor clusters in the range of about 3 kW up to 30 kW. It is optimal to have the SSTG as close as possible to a consumer of heat capacity, that make it possible to adopt present and existing infrastructure.

A first quadratic element for use with the present invention may be of various size, from a relatively small quadratic element having a length L and width W of about 1x1 m up to larger quadratic element of about 5x5 m. Preferably a length L and width W of a first quadratic element used with the present invention, as illustrated in Fig. 1, can be about 3x3 m. The thickness t1 of the first quadratic element can be relatively thin, from about 5 cm up to about 50 cm. Preferably the thickness t1 of the first quadratic element used with the present invention, as illustrated in fig. 1, can be from about 5 cm up to about 15 cm. Preferably, the module 1 may be provided in a standard sized container having dimensions of H 2438 mm x W 2 591 mm ISO container size for shipping, 20 ft or 40 ft.

Further, the fan unit 12 is schematically shown as a second quadratic element with a large, widely-spread front side surface and an opposite corresponding back side surface. The thickness of the second quadratic element may be relatively thin. Preferably the dimensions of the second quadratic element of the fan unit 12 used with the present invention, as illustrated in Fig. 1, have about the same dimensions as the first quadratic element of the compute unit 10 as described above.

As further shown in fig. 1, the fan unit 12 may comprise of at least four fan devices as schematically illustrated by the circular recesses 13 in fig. 1. However, the number of fan devices for each fan unit may be less or more than four.

Yet further, the heat exchanger unit 14 is schematically shown as a third quadratic element with a large, widely-spread front side surface 14a and an opposite corresponding back side surface 14b. The thickness t2 of the third quadratic element is larger than the thickness t1 of the first and second quadratic elements of the respectively compute unit 10 and the fan unit 12. The thickness t2 of the third quadratic element used with the present invention, as illustrated in fig. 1, can be from about 25 cm up to about 100 cm.

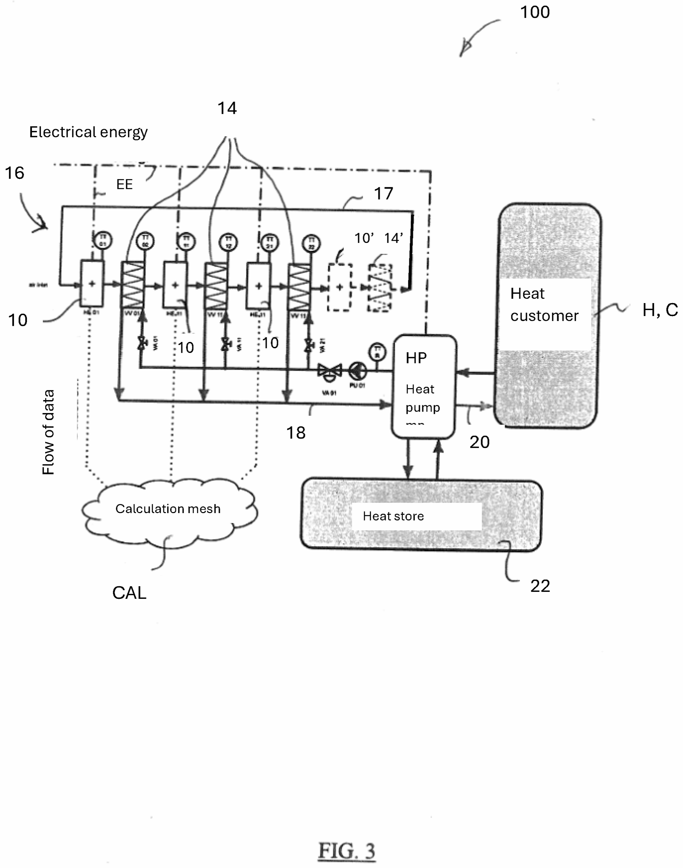

The compute unit 10 further comprises an inner closed circuit 17 (see description with reference to fig. 3 below) for recirculation of a cooling agent. The cooling agent is preferably a refrigerant comprising air, an inert gas, a gas mixture or a fluid medium.

Fig. 2 shows a solid state thermal generator (SSTG) 16 having several modules 1, such as ten modules 1 as shown in fig. 1. However, the number of modules 1 may be more, depending on the compute capacity of each module 1. The same reference numerals are used for the corresponding features as shown and described with reference to fig. 1.

The inner closed circuit 17 in one compute unit 10 is connected to adjacent inner closed circuits in adjacent compute units 10, in order to form an endless closed inner circuit when connecting a plurality of compute units 10 in a solid state thermal generator (SSTG) 16. The heat capacity produced in the compute units 10 is controlled by the load of the solid state thermal generator (SSTG), for instance whatever solid state processors used as mentioned above.

The heat exchanger unit 14 further comprises an outer circuit 18 (see description with reference to fig. 3 below) connected to adjacent outer closed circuits in adjacent heat exchanger units 14, in order to form an endless closed outer circuit when connecting a plurality of heat exchanger units 14 via a heating pump HP (see description with reference to fig. 3 below).

Electric energy EE (see description with reference to fig. 3 below) is provided to a heating pump as well as the compute units 10 and the fan units 12. The calculation units 10 provide compute results via a compute flow to a mesh (network) for compute calculations CAL (see description with reference to fig. 3 below).

The heat energy in the inner closed circuit 17 is exchanged to a fluid medium in the outer circuit 18 via the heat exchanger units 14. The fluid medium that can be either gas or liquid phase such as water or another liquid. The heat exchanger cools down the inner circuit in order to reach an optimal inner temperature in the cooling agent in the next compute unit 10. The amount of heat capacity transferred from the inner circuit is regulated by controlling the flow rate in the outer circuit.

Preferably the dimensions of the third quadratic element of a heat exchanger unit 14 used with the present invention, as illustrated in fig. 1, have about the same length and width dimensions as the first and second quadratic element of the respectively compute unit 10 and the fan unit 12 as described above.

The compute unit 10 and the fan unit 12 are supported at the lower portions on a displaceable foot support 15 which can be moved in a direction to and from the heat exchanger unit. Hence, the compute unit 10 and the fan unit 12 are displaceable arranged to the heat exchanger unit 14, via a displaceable foot support as shown in fig. 2. Moreover, the compute unit 10 and the fan unit 12 are displaceable arranged relative each other on the foot support 15 as shown in fig. 1 above. Hence, as shown in fig. 1, the compute unit 10 and the fan unit 12 have been displaced in a position away DP from the heat exchanger unit 14 for repair or service.

Fig. 3 shows a wiring diagram for a system 100 providing heat capacity from a solid state thermal generator (SSTG) 16 with three modules 1, comprising a compute unit 10, a fan unit 12 (see Figs. 1-2; not illustrated in Fig. 3) and a heat exchanger unit 14, as shown in figs 1 and 2, according to an embodiment of the invention. The same reference numerals are used for the corresponding features as shown and described with reference to fig. 1. There can be an infinite number of modules 1, as illustrated in Fig. 3 by a further compute unit 10' and a heat exchanger unit 14'. The SSTG 16 can be seen as a ring-formed arrangement, a doughnut or the like, as each layer of modules 1 feed the next after the extraction of the heat capacity.

The system 100 generate heat capacity H to customers C from the solid state thermal generator 16 having at three modules 1 comprising a compute unit 10, a fan unit 12 and a heat exchanger unit 14. The compute unit 10 perform computer-based calculations CAL that generate the heat capacity. The compute unit 10 further comprises an inner closed circuit 16 for recirculation of a cooling agent. The heat energy in the inner closed circuit 17 is exchanged to a fluid medium in an outer circuit 18 via the heat exchanger 14 that is positioned to receive the heat energy in the inner closed circuit 17. The heated fluid medium is supplied via a conduit 20 to customers for immediate consumption, to be stored in a heat capacity storage 22 or be dumped to the environment.

As mentioned above, electric energy EE is provided to a heating pump HP as well as to the compute units 10 and the fan units 14. The compute units 10 provide compute results via a compute flow to the mesh (network) for calculations CAL.

The heat capacity H from the solid state thermal generator (SSTG) 16 is provided to customers C in the vicinity to solid state thermal generator (SSTG) 16. In the system 100 according to the invention, the customers facilities such as buildings, industries and other facilities for commercial activities are preferably at a typical district heating distance from the solid state thermal generator (SSTG) 16 or less.

The system 100 generate heat capacity H for residential, commercial or industrial heating purposes. Which can be used for climate control of buildings and facilities as well as heat capacity needed for industrial processes. The primary energy source for the heating is electricity which powers a computational device, that generates heat capacity through resistance and inductive voltage drops.

The heat capacity is transferred from the solid state thermal generator (SSTG), that is the computational core of computers/processors in the compute units 10 by heat-conductors transferring the thermal energy to a transfer fluid which can be liquid or gas. The amount of heat power generated is controlled by altering the computational load on the core.

There are two ways, when compute capacity demand is higher than heat capacity supply then either, dump the heat capacity externally or use the heat capacity storage or reuse in another external system.

The other way is that you regulate the compute capacity load through SSTG management system.

The compute algorithms can be any suitable for the type of solid state thermal generator (SSTG) including software defined algorithms or file program arrays. The thermal temperature is controlled by cooling fluid mass flow, by controlling the coolant pump speed. As a byproduct, the system 100 delivers computational power for scientific, industrial, commercial or private purposes which can be consumed locally or delivered through the internet. The computational power is sold on the market using a computer controlled brokering system.

The system 100 may preferably have a heat pumping HP and storage system 22 to store heat capacity during low demand periods and deliver heat capacity during peak demand. The storage scheduling and system control is controlled with a computer with a manual backup panel.

The system 100 has safety functions, part of the solid state thermal generator (SSTG) management system, to prevent core overheat by lowering computational load in the case of core coolant exit temperature exceeded design maximum. For instance, the safety functions can be thermo couples and sensors monitoring the solid state thermal generator (SSTG).

The system can have a fuel powered heat source as backup, which is started in case of electrical grid failure.

It is to be understood that the present invention is not limited to the embodiments described above and illustrated in the drawings; rather, the skilled person will recognize that many changes and modifications may be made within the scope of the appended claims.

## Claims

1. A system (100) for providing heat capacity (H), which is the heat generated by a solid state thermal generator, SSTG (16), that is capable of transferring electrical energy into thermal energy for heating or cooling, from the solid state thermal generator (16) to customers (C); wherein the system comprises a plurality of modules (1);
each module (1) comprises a compute unit (10) provided with processors, a fan unit (12) and a heat exchanger unit (14),
wherein the compute unit (10) provides compute capacity (CAL) and a heat capacity (H)
generated by the processors,
wherein each compute unit (10) further comprises an inner closed circuit (17) for recirculation of a cooling agent, and the inner closed circuit (17) in one compute unit (10) is connected to adjacent inner closed circuits (10) in adjacent compute units (10), in order to form an endless closed inner circuit from the plurality of compute units (10) in said solid state thermal generator (16),
the heat energy in the inner closed circuit (17) is exchanged to a fluid medium in an outer circuit (18) via the heat exchanger units (14),
wherein the heated fluid medium is supplied via a conduit (20) to customers (C) for immediate consumption of said received heat energy, for storage of said received heat energy in a heat capacity storage system (22) or for dumping of said received heat energy **characterized in that**:
each compute unit (10) is a first quadratic element with a large, widely-spread front side surface (10a), an opposite corresponding back side surface (10b) and a thickness (t1);
each fan unit (12) is a second quadratic element with a large, widely-spread front side surface and an opposite corresponding back side surface and a thickness with about the same dimensions as said first quadratic element;
each heat exchanger unit (14) is a third quadratic element with a large, widely-spread front side surface (14a),
an opposite corresponding back side surface (14b) with about the same dimensions as said first and second quadratic elements and a thickness (t2) which is larger than the thickness (t1) of the first and second quadratic elements and wherein
said solid state thermal generator (16) is a ring-formed arrangement, wherein each of the modules (1) feeds the next module with cooling agent after the extraction of the heat capacity (H).

2. The system according to claim 1, wherein the first quadratic element has a length L and width W of about 1 m x 1 m up to about 5 m x 5 m and a thickness t1 from about 5 cm up to about 50 cm.

3. The system according to claim 1 or 2, wherein the thickness t2 of the third quadratic element is from about 25 cm up to about 100 cm.

4. The system according to any of the preceding claims, wherein the module 1 is provided in a standard sized ISO container for shipping, having dimensions of H 2438 mm x W 2 591 mm and length 6.1m (20 ft) or 12.2 m (40 ft).

5. The system according to any of the preceding claims, wherein the compute unit (10) and the fan unit (12) are supported at the lower portions on a displaceable foot support (15) which can be moved in a direction to and from the heat exchanger unit.

6. The system according to claim 5, wherein the compute unit (10) and the fan unit (12) are displaceably arranged relative each other on the foot support (15).

7. The system according to any of the preceding claims, wherein the system has a heat pumping and storage system (22) to store heat capacity during low demand periods and deliver heat capacity during peak demand.

8. The system according to any of the preceding claims, wherein the system (100), as a by-product, delivers computational power for scientific, industrial, commercial or private purposes which can be consumed locally or delivered through the internet.

9. A method for providing heat capacity (H) to customers (C) using the system (100) according to any of the preceding claims, wherein the method comprises the steps of:
producing heat capacity by the compute unit (10) in a module;
exchanging the heat energy in the inner closed circuit (17) to a fluid medium in an outer circuit (18) via the heat exchanger (14) in said module,
wherein the heated fluid medium is supplied via a conduit (20) to customers (C) for immediate consumption of said received heat energy, for storage of said received heat energy in a heat capacity storage system (22) or for dumping of said received heat energy.

10. Method according to claim 9, wherein the customers (C) are located in the vicinity of the solid state thermal generator (16) and the heat capacity (H) is provided, while providing compute capacity.

## Patentansprüche

1. System (100) zum Bereitstellen von Wärmekapazität (H), welche die durch einen Festkörper-Thermogenerator, SSTG (16), generierte Wärme ist, welcher dazu in der Lage ist, elektrische Energie zum Erwärmen oder Kühlen in thermische Energie umzuwandeln, von dem Festkörper-Thermogenerator (16) für Kunden (C), wobei das System eine Mehrzahl von Modulen (1) umfasst, wobei jedes Modul (1) eine Prozessoren aufweisende Recheneinheit (10), eine Gebläseeinheit (12) und eine Wärmetauschereinheit (14) umfasst,
wobei die Recheneinheit (10) durch die Prozessoren generierte Rechenkapazität (CAR) und Wärmekapazität (H) bereitstellt,
wobei jede Recheneinheit (10) ferner einen inneren geschlossenen Kreislauf (17) zu zum Rezirkulieren eines Kühlmittels umfasst und der innere geschlossene Kreislauf (17) in einer Recheneinheit (10) mit benachbarten inneren geschlossenen Kreisläufen (10) in benachbarten Recheneinheiten (10) verbunden ist, um einen endlosen geschlossenen inneren Kreislauf aus der Mehrzahl von Recheneinheiten (10) in dem Festkörper-Thermogenerator (16) zu bilden,
wobei die Wärmeenergie in dem inneren geschlossenen Kreislauf (17) über die Wärmetauschereinheiten (14) auf ein Fluidmedium in einem äußeren Kreislauf (18) übertragen wird,
wobei das erwärmte Fluidmedium über eine Leitung (20) zum sofortigen Verbrauch der empfangenen Wärmeenergie, zum Speichern der empfangenen Wärmeenergie in einem Wärmekapazität-Speichersystem (22) oder zum Weggeben der empfangenen Wärmeenergie an Kunden (C) geliefert wird, **dadurch gekennzeichnet, dass**:
jede Recheneinheit (10) ein erstes quadratisches Element mit einer großen, weit ausgedehnten Vorderseitenoberfläche (10a), einer entgegengesetzten entsprechenden Rückseitenoberfläche (10b) und einer Dicke (t1) ist,
jede Gebläseeinheit (12) ein zweites quadratisches Element mit einer großen, weit ausgedehnten Vorderseitenoberfläche und einer entgegengesetzten entsprechenden Rückseitenoberfläche und einer Dicke ist mit ungefähr den gleichen Abmessungen wie das erste quadratische Element,
jede Wärmetauschereinheit (14) ein drittes quadratisches Element mit einer großen, weit ausgedehnten Vorderseitenoberfläche (14a), einer entgegengesetzten entsprechenden Rückseitenoberfläche (14b) ist mit ungefähr den gleichen Abmessungen wie das erste und das zweite quadratische Element und einer Dicke (t2), welche größer ist als die Dicke (t1) des erste und des zweiten quadratischen Elements, und wobei der Festkörper-Thermogenerator (16) eine ringförmige Anordnung ist, wobei jedes der Module (1) das nächste Modul nach der Entnahme der Wärmekapazität (H) mit Kühlmittel speist.

2. System nach Anspruch 1, wobei das erste quadratische Element eine Länge L und eine Breite B von ungefähr 1m x 1m bis ungefähr 5 m x 5 m und eine Dicke t1 von ungefähr 5 cm bis ungefähr 50 cm aufweist.

3. System nach Anspruch 1 oder 2, wobei die Dicke t2 des dritten quadratischen Elements von ungefähr 25 cm bis zu ungefähr 100 cm beträgt.

4. System nach einem der vorangehenden Ansprüche, wobei das Modul (1) zum Transport in einem Standardgrößen-ISO-Container mit Abmessungen von H 2438 mm x W 2591 mm und einer Länge von 6,1 m (20 ft) oder 12,2 m (40 ft) vorgesehen ist.

5. System einem der vorangehenden Ansprüche, wobei die Recheneinheit (10) und die Gebläseeinheit (12) an den unteren Abschnitten eines bewegbaren Fußträgers (15) getragen sind, welcher in einer Richtung zu und von der Wärmetauschereinheit bewegt werden kann.

6. System nach Anspruch 5, wobei die Recheneinheit (10) und die Gebläseeinheit (12) bezüglich einander bewegbar an dem Fußträger (15) angeordnet sind.

7. System nach einem der vorangehenden Ansprüche, wobei das System ein Wärmepump- und Speichersystem (22) zum Speichern von Wärmekapazität während Perioden mit geringem Bedarf und Abgeben von Wärmekapazität während eines Spitzenbedarfs aufweist.

8. System nach einem der vorangehenden Ansprüche, wobei das System (100) als Nebenprodukt Rechenleistung für wissenschaftliche, industrielle, kommerzielle oder private Zwecke liefert, welche lokal genutzt oder durch das Internet bereitgestellt werden kann.

9. Verfahren zum Bereitstellen von Wärmekapazität (H) für Kunden (C) unter Verwendung des Systems (100) einem der vorangehenden Ansprüche, wobei das Verfahren die Schritte umfasst:
Erzeugen von Wärmekapazität durch die Recheneinheit (10) in einem Modul,
Übertragen der Wärmeenergie in dem inneren geschlossenen Kreislauf (17) auf ein Fluidmedium in einem äußeren Kreislauf (18) über den Wärmetauscher (14) in dem Modul,
wobei das erwärmte Fluidmedium über eine Leitung (20) zum sofortigen Verbrauch der empfangenen Wärmeenergie, zum Speichern der empfangenen Wärmeenergie in einem Wärmekapazität-Speichersystem (22) oder zum Weggeben der empfangenen Wärmeenergie zu Kunden (C) geliefert wird.

10. Verfahren nach Anspruch 9, wobei die Kunden (C) in der Umgebung des Festkörper-Thermogenerator (16) lokalisiert sind und die Wärmekapazität (H) während des Bereitstellens von Rechenkapazität bereitgestellt wird.

## Revendications

1. Système (100) pour fournir une capacité thermique (H), qui est la chaleur générée par un générateur thermique à l'état solide, SSTG (16), capable de transférer de l'énergie électrique en énergie thermique pour le chauffage ou le refroidissement, depuis le générateur thermique à l'état solide (16) jusqu'aux clients (C) ; dans lequel le système comprend une pluralité de modules (1) ;
chaque module (1) comprend une unité de calcul (10) pourvue de processeurs, une unité de ventilateur (12) et une unité d'échangeur de chaleur (14),
dans lequel l'unité de calcul (10) fournit une capacité de calcul (CAL) et une capacité thermique (H) générées par les processeurs,
dans lequel chaque unité de calcul (10) comprend en outre un circuit fermé interne (17) pour la recirculation d'un agent de refroidissement, et le circuit fermé interne (17) dans une unité de calcul (10) est connecté à des circuits fermés internes (10) adjacents dans des unités de calcul (10) adjacentes, afin de former un circuit fermé interne sans fin à partir de la pluralité d'unités de calcul (10) dans ledit générateur thermique à l'état solide (16),
l'énergie thermique dans le circuit fermé interne (17) est échangée vers un milieu fluide dans un circuit externe (18) via les unités d'échangeur de chaleur (14),
dans lequel le milieu fluide chauffé est alimenté via un conduit (20) vers des clients (C) pour une consommation immédiate de ladite énergie thermique reçue, pour un stockage de ladite énergie thermique reçue dans un système de stockage de capacité thermique (22) ou pour l'évacuation de ladite énergie thermique reçue, **caractérisé en ce que** :
chaque unité de calcul (10) est un premier élément quadratique avec une grande surface latérale avant largement étalée (10a), une surface latérale arrière (10b) correspondante opposée et une épaisseur (t1) ; chaque unité de ventilateur (12) est un deuxième élément quadratique avec une grande surface latérale avant largement étalée et une surface latérale arrière correspondante opposée et une épaisseur avec environ les mêmes dimensions que ledit premier élément quadratique ;
chaque unité d'échangeur de chaleur (14) est un troisième élément quadratique avec une grande surface latérale avant largement étalée (14a),
une surface latérale arrière (14b) correspondante opposée avec environ les mêmes dimensions que lesdits premier et deuxième éléments quadratiques et une épaisseur (t2) qui est supérieure à l'épaisseur (t1) des premier et deuxième éléments quadratiques et dans lequel
ledit générateur thermique à l'état solide (16) est un agencement en forme d'anneau, dans lequel chacun des modules (1) approvisionne le module suivant avec un agent de refroidissement après l'extraction de la capacité thermique (H).

2. Système selon la revendication 1, dans lequel le premier élément quadratique a une longueur L et une largeur W d'environ 1 m x 1 m jusqu'à environ 5 m x 5 m et une épaisseur t1 d'environ 5 cm jusqu'à environ 50 cm.

3. Système selon la revendication 1 ou 2, dans lequel l'épaisseur t2 du troisième élément quadratique est d'environ 25 cm jusqu'à environ 100 cm.

4. Système selon l'une quelconque des revendications précédentes, dans lequel le module 1 est fourni dans un contenant ISO de taille standard pour l'expédition, ayant des dimensions de H 2438 mm x W 2591 mm et une longueur de 6,1 m (20 pi) ou 12,2 m (40 pi).

5. Système selon l'une quelconque des revendications précédentes, dans lequel l'unité de calcul (10) et l'unité de ventilateur (12) sont supportées au niveau des portions inférieures sur un support de pied déplaçable (15) qui peut être déplacé dans une direction vers et depuis l'unité d'échangeur de chaleur.

6. Système selon la revendication 5, dans lequel l'unité de calcul (10) et l'unité de ventilateur (12) sont agencées de manière déplaçable l'une par rapport à l'autre sur le support de pied (15).

7. Système selon l'une quelconque des revendications précédentes, dans lequel le système a un système de pompage et de stockage de chaleur (22) pour stocker la capacité thermique pendant les périodes de faible demande et délivrer la capacité thermique pendant la demande de pointe.

8. Système selon l'une quelconque des revendications précédentes, dans lequel le système (100), en tant que sous-produit, délivre une puissance de calcul à des fins scientifiques, industrielles, commerciales ou privées qui peut être consommée localement ou délivrée par l'Internet.

9. Procédé pour fournir une capacité thermique (H) à des clients (C) en utilisant le système (100) selon l'une quelconque des revendications précédentes, dans lequel le procédé comprend les étapes suivantes :
la production de capacité thermique par l'unité de calcul (10) dans un module ;
l'échange de l'énergie thermique dans le circuit fermé interne (17) vers un milieu fluide dans un circuit externe (18) via l'échangeur de chaleur (14) dans ledit module,
dans lequel le milieu fluide chauffé est alimenté via un conduit (20) vers des clients (C) pour une consommation immédiate de ladite énergie thermique reçue, pour un stockage de ladite énergie thermique reçue dans un système de stockage de capacité thermique (22) ou pour l'évacuation de ladite énergie thermique reçue.

10. Procédé selon la revendication 9, dans lequel les clients (C) sont situés à proximité du générateur thermique à l'état solide (16) et la capacité thermique (H) est fournie, tout en fournissant une capacité de calcul.
